# EUROPÄISCHE PATENTSCHRIFT

(11) **EP 2 898 544 B1**
(45) Veröffentlichungstag und Bekanntmachung des Hinweises auf die Patenterteilung: **08.08.2018**
(21) Anmeldenummer: 13765723.5
(22) Anmeldetag: 19.09.2013
(51) Int. Cl.: H01L 31/105, H01L 31/0232, H01L 31/0224, H01L 31/028

(54) **GERMANIUM PIN-FOTODIODE FÜR DIE INTEGRATION IN EINE CMOS- ODER BICMOS-TECHNOLOGIE**
GERMAINIUM PIN PHOTODIODE FOR INTEGRATION INTO A CMOS OR BICMOS TECHNOLOGY
PHOTODIODE PIN EN GERMANIUM CONÇUE POUR ÊTRE INTÉGRÉE À UNE TECHNOLOGIE CMOS OU BICMOS

(30) Priorität: 19.09.2012 DE 102012216811; 31.01.2013 DE 102013201644
(43) Veröffentlichungstag der Anmeldung: 29.07.2015
(73) Patentinhaber: IHP GmbH-Innovations for High Performance Microelectronics / Leibniz-Institut für innovative Mikroelektronik, 15236 Frankfurt / Oder (DE)
(72) Erfinder: KNOLL, Dieter, 15230 Frankfurt (Oder) (DE); LISCHKE, Stefan, 15232 Frankfurt (Oder) (DE); ZIMMERMANN, Lars, 10623 Berlin (DE); YAMAMOTO, Yuji, 15230 Frankfurt (Oder) (DE); TRUSCH, Andreas, 15236 Frankfurt (Oder) (DE)
(74) Vertreter: Eisenführ Speiser
(86) Internationale Anmeldenummer: PCT/EP2013/069511
(87) Internationale Veröffentlichungsnummer: WO 2014/044771

(56) Entgegenhaltungen:
- US-A1- 2007 104 441
- US-A1- 2009 108 384
- US-B1- 6 635 110
- US-B1- 7 340 709
- LISCHKE S ET AL: "Low dark current Ge PIN photodiode for a high-performance, photonic BiCMOS process for radio-over-fiber applications", PHOTONICS CONFERENCE (IPC), 2012 IEEE, IEEE, 23. September 2012 (2012-09-23), Seiten 628-629, XP032269241, DOI: 10.1109/IPCON.2012.6358778 ISBN: 978-1-4577-0731-5
- LOH W Y ET AL: "Impact of Local Strain From Selective Epitaxial Germanium With Thin Si/SiGe Buffer on High-Performance p-i-n Photodetectors With a Low Thermal Budget", IEEE ELECTRON DEVICE LETTERS, IEEE SERVICE CENTER, NEW YORK, NY, US, Bd. 28, Nr. 11, November 2007 (2007-11), Seiten 984-986, XP011196026, ISSN: 0741-3106, DOI: 10.1109/LED.2007.906814

## Beschreibung

Die Erfindung betrifft eine Diode mit einem Germanium-Gebiet. Weiterhin betrifft die Erfindung ein Verfahren zur Herstellung einer solchen Diode.

Optische und opto-elektronische Komponenten, hergestellt mit einer Silizium-basierten Technologie, sind Schlüsselbausteine z. B. für optische Telekommunikation oder optische Verbindungen in oder zwischen mikroelektronischen Schaltungen. Beispiele solcher Komponenten sind Koppler, Wellenleiter, Modulatoren und insbesondere Fotodetektoren.

Moderne Fotodetektoren nutzen Germanium als Detektormaterial auf Grund seines deutlich besseren Absorptionsvermögens gegenüber Silizium im für optische Kommunikation genutzten Wellenlängenbereich (1,3 - 1,6 µm). Oftmals wird als Detektor eine sogenannte PIN-Diode genutzt ("P" für p-dotiertes Gebiet, "I" für intrinsisches Gebiet und "N" für n-dotiertes Gebiet). Wichtige Parameter der Diode sind Dunkelstrom, Fotostrom, Empfindlichkeit und optische Bandbreite. Mit einer Weite der intrinsischen Region von einigen hundert Nanometern wurden schon sehr schnelle Ge-Fotodioden mit einer optischen Bandbreite um 50 GHz demonstriert.

Typischerweise werden solche Dioden durch epitaktisches Wachstum direkt auf SOI-Substrat hergestellt, was eine direkte Ankopplung des Detektors an den Wellenleiter, hergestellt aus der oberen, einkristallinen Si-Schicht der SOI-Struktur, gestattet. Dadurch kann das zu detektierende Licht lateral der Diode zugeführt werden, was eine unabhängige Dioden-Optimierung hinsichtlich Empfindlichkeit und optischer Bandbreite erlaubt.

Laterale Germanium PIN-Detektoren auf Silizium sind zum Beispiel aus der Veröffentlichung "Loh et al, IEEE Electron Device Letters, Vol. 28, No. 11, November 2007, p. 984-986" bekannt.

Die Erfindung betrifft eine laterale PIN-Diode gemäß dem Patentanspruch 1. Gemäß der Erfindung enthält eine laterale PIN-Diode ein lichtempfindliches Germanium-Gebiet, das völlig in Silizium eingebettet ist und mit dem Silizium eine untere Grenzfläche sowie seitliche Grenzflächen bildet, wobei die seitlichen Grenzflächen nicht senkrecht, sondern schräg zur unteren Grenzfläche verlaufen und daher eine Facetten-Form bilden. Bei der erfindungsgemäßen Diode weist das Germanium-Gebiet einen nur intrinsisch leitfähigen Abschnitt auf, der sich unterhalb eines auf dem Silizium angeordneten Isolatorschicht-Streifens erstreckt, dessen laterale Ausdehnung das intrinsische Gebiet der Diode bestimmt. Seitlich an den intrinsisch leitfähigen Abschnitt des Germanium-Gebiets schließen dotierte Germanium- und Silizium-Gebiete anschließen, die sich lateral vom intrinsischen Germanium-Gebiet der Diode bis zu einem von einem Isolator begrenzten Diodenrand erstrecken. Die Diode der vorliegenden Erfindung ermöglicht es, in bevorzugten Ausführungsformen eine laterale PIN-Fotodiode bereitzustellen, die sowohl das Erreichen sehr guter Parameter, wie insbesondere niedrige Dunkelströme und hohe optische Bandbreite, erlaubt, aber auch wesentliche Anforderungen für die Integration in eine CMOS- oder BiCMOS-Technologie, wie begrenzte vertikale Höhe und Nutzung des im CMOS- oder BiCMOS-Prozess verwendeten Kontakt- und Metallisierungssystems, insbesondere der selbstjustierten Silizidbildung, erfüllt und deren Struktur außerdem zu keinen Einschränkungen oder Änderungen von Reinigungs- und Nassätzschritten des CMOS- oder BiCMOS-Prozesses führt, die nach Abscheidung der Ge-Epitaxieschicht angewandt werden müssen.

### Der Erfindung liegen folgende Überlegungen zugrunde:

Für die monolithische Integration einer Germanium PIN-Fotodiode in eine CMOS- oder BiCMOS-Technologie wäre eine sogenannte "Front-end integration" vorteilhaft, wo die wesentlichen Prozessschritte zur Herstellung des Detektors vor Herstellung der Metallisierungsschichten der CMOS- oder BiCMOS-Technologie ausgeführt werden und die elektrische Verbindung des Detektors mit den elektrischen Komponenten, wie Transistoren, Widerständen u.a., des CMOS- oder BiCMOS-Prozesses unter Nutzung der Kontakt- und Metallisierungs-Schichten des CMOS- oder BiCMOS-Prozesses erfolgt.

Mit Weiterbildungen der Diode können nun auch wesentliche Anforderungen für die Integration in eine CMOS- oder BiCMOS-Technologie, wie eine begrenzte vertikale Höhe und eine Nutzung des im CMOS- oder BiCMOS-Prozess verwendeten Kontakt- und Metallisierungssystems, insbesondere der selbstjustierten Silizidbildung, erfüllt werden. Außerdem können mit der erfindungsgemäßen Diodenstruktur in bevorzugten Ausführungsformen Einschränkungen oder Änderungen von Reinigungs- und Nassätzschritten des CMOS- oder BiCMOS-Prozesses vermieden werden, die im Stand der Technik nach Abscheidung der Ge-Epitaxieschicht angewandt werden müssten.

Die erfindungsgemäße Diode kann darüber hinaus in Ausführungsbeispielen mit einer großen optischen Bandbreite hergestellt werden. Eine wichtige Voraussetzung für eine solche hohe optische Bandbreite der Fotodiode sind steile Dotierungsprofile. Allerdings sind die Diffusionskoeffizienten mancher Dotanden (z. B. Phosphor) in Germanium höher als in Silizium. Die Struktur der erfindungsgemäßen PIN-Diode ermöglicht es, in bevorzugten Ausführungsformen eine Diodenstruktur zu bilden, bei der im Wesentlichen nur das intrinsische Gebiet aus Germanium besteht, während für die Ausbildung der dotierten Gebiete weitestgehend Silizium genutzt wird.

Nachfolgend werden bevorzugte Ausführungsformen der Diode und die damit verbundenen Vorteile beschrieben.

Das Germanium-Gebiet verjüngt sich bevorzugt von der unteren Grenzfläche ausgehend mit zunehmendem Abstand von der unteren Grenzfläche. Die seitlichen Grenzflächen sind bei dieser Ausführungsform bevorzugt durch selektiv zu einer Isolatorschicht durchgeführtes epitaktisches Wachstum des Germanium-Gebiets auf einer (100)-orientierten Silizium-Unterlage hergestellt.

Eine gesamte Höhe der Diode über der unteren Grenzfläche beträgt vorzugsweise höchstens 700 nm, in besonders bevorzugten Ausführungsformen höchstens 500 nm, wobei diese Höhe eine maximale Dicke des Germanium-Gebiets über der unteren Grenzfläche und eine Dicke eines Silizium-Schichtabschnitts über dem Germanium-Gebiet einschließt. Mit einer totalen Höhe des Detektors von nicht mehr als 500 - 700 nm, gemessen von der unteren Grenzfläche, wird die oben genannte Anforderung meist ausreichend gut erfüllt, wonach der Detektor eine bestimmte totale Höhe nicht überschreiten sollte, um Kontakthöhen für die Diode zu gewährleisten, die nicht deutlich geringer sind als die Transistor-Kontakthöhen des CMOS- oder BiCMOS-Prozesses.

Diese Anforderung kann allerdings eine deutliche Einschränkung hinsichtlich des erreichbaren Dioden-Dunkelstromniveaus bedeuten, wenn man bedenkt, dass die Defektdichte von Germanium-Schichten, hergestellt mittels Hetero-Epitaxie auf Silizium-Substrat, mit zunehmender Dicke der Germanium-Schicht stark abnimmt. Eine nur 500 nm dicke Germanium-Schicht kann z. B. eine rund 100-mal höhere Versetzungsdichte im Vergleich zu einer 4,5 µm dicken Schicht aufweisen.

Die Dicke des Silizium-Schichtabschnitts über dem Germanium-Gebiet hat, gerechnet vom ebenen, facettenfreien Teil einer oberen Grenzfläche zwischen dem Germanium-Gebiet und dem Silizium in verschiedenen alternativen Ausführungsformen einen Wert, der zwischen 20 und 150 nm liegt.

Auf den dotierten Siliziumgebieten ist vorzugsweise eine Metall-Silizidschicht ausgebildet ist, die mit weiteren Kontaktstrukturen verbindbar ist. Für sehr schnelle Fotodioden ist ein damit erzielbarer geringer Kontaktwiderstand zu den dotierten Gebieten von großer Bedeutung.

Durch die Verwendung des Isolator-Streifens ist sogar eine selbstjustierte Silizidbildung ermöglicht, ähnlich oder sogar identisch zu der, die in CMOS- oder BiCMOS-Prozessen typischerweise für die Transistoren angewandt wird. Leider ist eine Silizidbildung direkt auf Germanium, wenn man sie simultan mit der Silizidbildung des CMOS- oder BiCMOS-Prozesses ausführt, in Abhängigkeit vom verwendeten Metall deutlich erschwert oder überhaupt nicht möglich.

Dabei schließen an den Isolatorschicht-Streifen seitlich vorzugsweise Abstandshalter (Spacer) an, die einen Abstand zwischen dem Isolatorschicht-Streifen und der Metall-Silizidschicht definieren.

Anwendung findet die erfindungsgemäße Diode oder eine ihrer hier beschriebenen Ausführungsformen vorteilhafterweise als Fotodiode, insbesondere in einem optoelektronischen Bauelement, das außer der Diode mindestens ein monolithisch integriertes, lichtleitendes Bauelement aufweist. Das lichtleitende Bauelement ist beispielsweise ein Wellenleiter, der aus Silizium gefertigt ist und der mit dem Germanium-Gebiet der Diode die untere Grenzfläche bildet.

Im Folgenden werden die Merkmale und Vorteile der erfindungsgemäßen PIN-Fotodiode im Zusammenhang mit der Beschreibung weiterer Ausführungsbeispiele anhand der anhängenden Figuren näher erläutert.
Fig. 1 zeigt ein erstes Stadium eines Beispiels für ein Herstellungsverfahren einer Ausführungsform einer Diodenstruktur.
Fig. 2 bis 5 zeigen ein zweites bis fünftes Stadium des Herstellungsverfahrens der Ausführungsform der Diodenstruktur.
Fig. 6 zeigt ein sechstes Stadium des Herstellungsverfahrens der Ausführungsform der Diodenstruktur und zugleich die fertiggestellte Ausführungsform der erfindungsgemäßen Diodenstruktur.

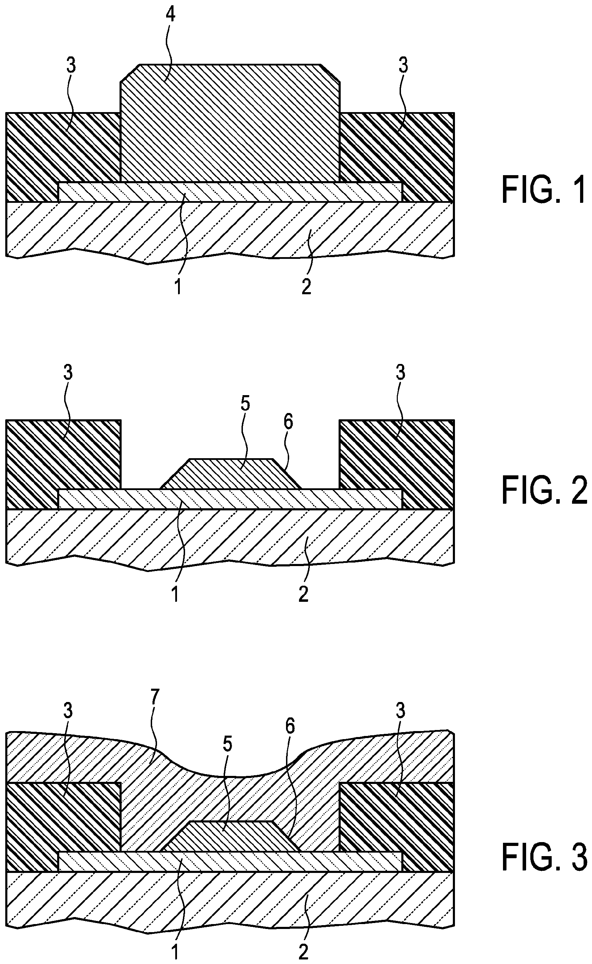

Die Figuren 1 bis 6 illustrieren anhand von schematischen Querschnittdarstellungen in unterschiedlichen Prozessstadien ein Beispiel eines Herstellungsprozess einer Ausführungsform der erfindungsgemäßen PIN-Fotodiode und illustrieren deren Merkmale. Alle Abbildungen zeigen Struktur-Querschnitte senkrecht zur Einfallsrichtung des Lichtes.

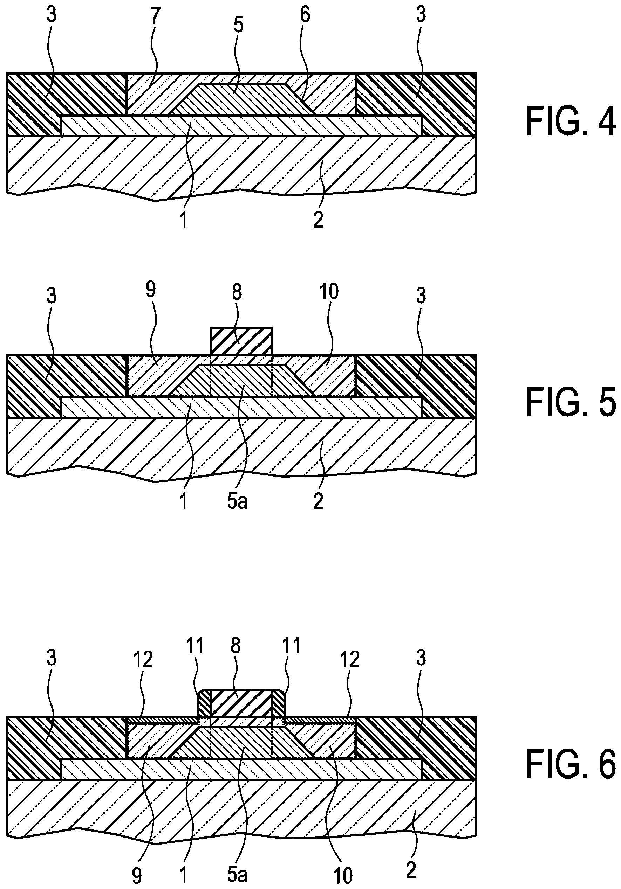

Nachfolgend wird zunächst anhand der Figuren 4 und 6 eine Ausführungsform einer erfindungsgemäßen lateralen PIN-Fotodiode beschrieben.

Auf einem einkristallinen Silizium-Wellenleiter 1, hergestellt auf einer Siliziumdioxid-Schicht 2, befindet sich eine Germanium-Schicht 5, welche seitlich und oberhalb von einer Silizium-Schicht 7 bedeckt ist. Wesentlich ist eine schräge Flanke einer von der Germanium-Schicht 5 und der Silizium-Schicht gebildeten seitlichen Grenzfläche 6, die nachfolgend als Germanium-Silizium-Grenzfläche bezeichnet wird und deren Entstehung später noch beschrieben wird. Die ganze Dioden-Struktur wird seitlich von einer Isolator-Schicht 3, vorzugsweise einer Silizium-Oxid-Schicht umhüllt. Die Dioden-Struktur ist mit einem Isolatorschicht-Streifen 8 bedeckt, der, wie unten näher erläutert wird, eine zu p- und n-dotierten Gebieten 9 und 10 selbstjustierte Herstellung eines intrinsischen Germanium-Gebietes 5a ermöglicht. Seitliche Isolator-Schicht-Spacer 11 sind optional. Ihr Nutzen ist es, die Sicherheit bei der Vermeidung unerwünschter Dioden-Leckströme zu erhöhen, welche durch Berührung von auf den p- und n-dotieren Gebieten 9 und 10 ausgebildeten Metall-Silizid-Schichten 12 mit dem intrinsischen Gebiet 5a auftreten würden.

Nachfolgend wird anhand aller Figuren ein Beispiel eines Herstellungsprozesses der gerade erläuterten PIN-Fotodiode beschrieben.

Fig. 1 zeigt ein erstes Stadium eines Beispiels für ein Herstellungsverfahren einer Ausführungsform einer Diodenstruktur. In diesem Stadium ist nach einem selektiven epitaktischen Wachstum eine Germanium-Schicht 4 in einem Fenster in einer Isolator-Schicht 3 entstanden. Die Isolator-Schicht ist in diesem Beispiel eine Silizium-Oxid-Schicht. Die Germanium-Schicht 4 und zu einem Teil auch die Isolator-Schicht 3 liegen auf einem vorher hergestellten einkristallinen Silizium-Wellenleiter 1 auf, der sich auf einer Silizium-Oxid-Schicht 2 befindet. Die Dicke der Germanium-Schicht 4 kann hier deutlich dicker sein als die gewünschte Enddicke des Germanium-Gebietes der fertigen Fotodiode. Eine für selektives Ge-Wachstum auf (100)-orientiertem Silizium typische Facetten-Bildung auf der Schichtoberseite der Germanium-Schicht 4 ist in Fig. 1 durch schräge Kanten angedeutet. Die Dicke der Isolator-Schicht 3 über dem Wellenleiter 1 wird so gewählt, dass sie etwa der gewünschten, CMOS- bzw. BiCMOS-kompatiblen totalen Detektorhöhe entspricht.

Fig. 2 zeigt ein zweites Stadium der Herstellung der Ausführungsform der Diodenstruktur. Viele Chemikalien, die im CMOS- oder BiCMOS-Prozess für Reinigungs- oder Ätzschritte genutzt werden, haben keine ausreichende Selektivität zu Germanium, d. h. greifen die gewachsene Germanium-Schicht stark an, was die Integration des Herstellungsprozesses für die Germanium PIN Fotodioden in den CMOS- oder BiCMOS-Prozessablauf außerordentlich erschweren kann. Daher wird bei dem vorliegenden Ausführungsbeispiel als alternative Lösung ein Gasphasen-Rückätzprozess verwendet. Dieser Gasphasen-Rückätzprozess ist als solcher bereits bekannt, und zwar aus der Veröffentlichung Y. Yamamoto et al, Thin Solid Films S, 520 (2012) 3216-3221. Er kann unmittelbar nach Herstellen der Germanium-Schicht 4 in derselben Anlage ausgeführt werden und erfordert keinerlei zusätzliche Reinigungsschritte vor den nachfolgenden Prozess-Schritten zur Fertigstellung der Fotodiode.

Fig. 2 zeigt die Diodenstruktur nach einem solchen Gasphasen-Rückätzprozess. Der Ätzprozess wird so gesteuert, dass hierbei die finale Höhe der so prozessierten Germanium-Schicht, die von hier an in den Figuren mit dem Bezugszeichen 5 versehen ist, über dem Wellenleiter eingestellt wird. Beim Ätzprozess bildet sich eine in Fig. 2 angedeutete charakteristische Struktur mit einer seitlichen Facette 6. Die Prozessfolge "Abscheiden einer relativ dicken Germanium-Schicht" und "nachfolgendes Rückätzen" erlaubt, wie in Y. Yamamoto et al, Thin Solid Films S, 520 (2012) 3216-3221 beschrieben, die Herstellung "dünner" Ge-Schichten" mit einer niedrigen Defektdichte, wie sie sonst nur für "dickere" Schichten erreichbar ist. Diese Vorgehensweise ist wesentlich für das Erreichen eines niedrigen Dunkelstrom-Niveaus der Foto-Dioden.

Die Figuren 3 und 4 zeigen ein drittes und ein viertes Stadium der Herstellung der Ausführungsform der Diodenstruktur. Fig. 3 zeigt die Diodenstruktur nach Abscheidung einer Silizium-Schicht 7 mittels nicht-selektiver Silizium-Epitaxie. Fig. 4 zeigt die Diodenstruktur nach deren danach durchgeführter Planarisierung mittels Chemisch-Mechanischem Polieren (CMP). Wesentlich ist, dass nach diesen Prozess-Schritten das Germanium-Gebiet der Diode vollständig von Silizium umhüllt ist. Das erlaubt einerseits im Weiteren die uneingeschränkte Anwendung üblicher Reinigungs- und Nassätzprozesse der CMOS- oder BiCMOS-Technologie und andererseits die Nutzung des gleichen Metall-Silizides für CMOS- oder BiCMOS-Komponenten und Fotodiode.

Fig. 5 zeigt als fünftes Stadium der Herstellung dieser Ausführungsform der Diodenstruktur eine Phase während einer selbstjustierten Herstellung einer PIN-Struktur mit Hilfe eines Isolator-Streifens 8. Dessen Dicke wird so gewählt, das während einer danach durchgeführten Implantation der p- und n-Gebiete 9 und 10 keinerlei Dotierung unterhalb des Streifens eingebracht wird. Dies ist in Fig. 5 dadurch graphisch angedeutet, dass die p- und n-Gebiete dunkler dargestellt sind als ein sich zwischen ihnen und unter dem Isolator-Streifen 8 liegender Bereich 5a. So können innere Kanten von für die p- und- n-Implantation genutzten Lackmasken (nicht dargestellt) direkt auf dem Isolator-Streifen 8 positioniert werden, ohne dass Justage-Schwankungen der Lackmasken zum Isolator-Streifen 8 zu Schwankungen der gewünschten Breite des intrinsischen Germanium-Gebietes 5a führen. Somit lässt sich die Breite des intrinsischen Germanium-Gebietes, die sehr wichtig für die optische Bandbreite ist, sehr genau einstellen.

Wesentlich ist auch, dass mit der Breite des Isolator-Streifens 8 nicht nur die Breite des intrinsischen Germanium-Gebietes eingestellt werden kann, sondern auch das Verhältnis zwischen dotierten Germanium- und Silizium-Gebieten, was sich zu einer Bandbreiten-Optimierung der Dioden ausnutzen lässt.

Fig. 6 demonstriert als sechstes Stadium der Herstellung dieser Ausführungsform der Diodenstruktur die finale Diodenstruktur vor Herstellung von Dioden-Kontakten. Eine Metall-Silizid-Schicht 12 ist durch eine selbstjustierte Ausbildung unter optionaler Ausnutzung von Isolator-Schicht-Spacern 11 über den p- und n-Gebieten 9 und 10 hergestellt worden. Dadurch können niedrige Kontaktwiderstände realisiert werden, die wiederum günstig für das Erreichen einer hohen optischen Bandbreite sind.

Mit der hier erreichten Struktur können die in CMOS- oder BiCMOS-Prozessen üblicherweise genutzten Kontakte (z. B. sogenannte Wolfram-Plugs, nicht dargestellt) gewissermaßen mitgenutzt werden.

## Patentansprüche

1. Laterale PIN-Diode, mit
- einem lichtempfindlichen Germanium-Gebiet (5), das völlig in Silizium (1, 7) eingebettet ist und mit dem Silizium (1, 7, 9, 10) eine untere Grenzfläche (1) sowie seitliche Grenzflächen (6) bildet, wobei die seitlichen Grenzflächen nicht senkrecht, sondern schräg zur unteren Grenzfläche verlaufen und daher eine Facetten-Form bilden,
- bei der das Germanium-Gebiet (5) einen nur intrinsisch leitfähigen Abschnitt (5a) aufweist, der sich unterhalb eines auf dem Silizium (7) angeordneten Isolatorschicht-Streifens (8) erstreckt, dessen laterale Ausdehnung das intrinsische Gebiet der Diode bestimmt, und
- bei der seitlich an den intrinsisch leitfähigen Abschnitt (5a) des Germanium-Gebiets (5) dotierte Germanium- und Silizium-Gebiete (5, 9, 10) anschließen, die sich lateral vom intrinsischen Germanium-Gebiet (5a) der Diode bis zu einem von einem Isolator (3) begrenzten Diodenrand erstrecken.

2. Diode nach Anspruch 1, bei der sich das Germanium-Gebiet (5) von der unteren Grenzfläche (1) ausgehend mit zunehmendem Abstand von der unteren Grenzfläche verjüngt, wobei die seitlichen Grenzflächen (6) bevorzugt durch selektiv zu einer Isolatorschicht durchgeführtes epitaktisches Wachstum des Germanium-Gebiets auf einer (100)-orientierten Silizium-Unterlage (1) hergestellt sind.

3. Diode nach Anspruch 1 oder 2, bei der eine gesamte Höhe der Diode über der unteren Grenzfläche (1) höchstens 700 nm beträgt, wobei diese Höhe eine maximale Dicke des Germanium-Gebiets (5) über der unteren Grenzfläche (1) und eine Dicke eines Silizium-Schichtabschnitts (7) über dem Germanium-Gebiet einschließt.

4. Diode nach Anspruch 3, bei der die gesamte Höhe höchstens 500 nm beträgt.

5. Diode nach Anspruch 3 oder 4, bei der die Dicke des Silizium-Schichtabschnitts (7) über dem Germanium-Gebiet, gerechnet vom ebenen, facettenfreien Teil einer oberen Grenzfläche zwischen dem Germanium-Gebiet und dem Silizium zwischen 20 und 150 nm beträgt.

6. Diode nach mindestens einem der vorstehenden Ansprüche, mit einer Metall-Silizidschicht (12), die auf den dotierten Siliziumgebieten (9, 10) ausgebildet ist.

7. Diode nach Anspruch 6, bei dem an den Isolatorschicht-Streifen (8) seitlich Abstandshalter (11) anschließen, die einen Abstand zwischen dem Isolatorschicht-Streifen und der Metall-Silizidschicht (12) definieren.

8. Opto-elektronisches Bauelement, mit einer Diode nach mindestens einem der vorstehenden Ansprüche und einem mit der Diode monolithisch integrierten, lichtleitenden Bauelement (1).

9. Opto-elektronisches Bauelement nach Anspruch 8, bei dem das lichtleitende Bauelement ein Wellenleiter (1) ist, der aus Silizium gefertigt ist und mit dem Germanium-Gebiet (5) der Diode die untere Grenzfläche bildet.

## Claims

1. Lateral PIN diode, comprising
- a light-sensitive germanium region (5) which is totally embedded in silicon (1, 7) and forms with the silicon (1, 7, 9, 10) a lower interface (1) and lateral interfaces (6), wherein the lateral interfaces do not extend perpendicularly, but obliquely to the lower interface and therefore produce a faceted form,
- wherein the germanium region (5) has a portion (5a) which is only intrinsically conductive and which extends below an insulating strip (8) arranged on the silicon (7), the lateral extension of said strip determining the intrinsic region of the diode, and
- wherein doped germanium and silicon regions (5, 9, 10) laterally adjoin the intrinsically conductive portion (5a) of the germanium region (5) and extend laterally from the intrinsic germanium region (5a) of the diode to a diode edge defined by an insulator (3).

2. Diode according to claim 1, wherein the germanium region (5) tapers from the lower interface (1) with increasing distance from the lower interface, the lateral interfaces (6) preferably being produced by epitaxial growth of the germanium region on a (100)-oriented silicon base (1) selectively with respect to an insulating layer.

3. Diode according to claim 1 or 2, wherein the total height of the diode above the lower interface (1) is 700 nm at most, said height including a maximum thickness of the germanium region (5) over the lower interface (1) and a thickness of a portion of the silicon layer (7) above the germanium region.

4. Diode according to claim 3, wherein the total height is 500 nm at most.

5. Diode according to claim 3 or 4, wherein the thickness of the silicon layer portion (7) over the germanium region, measured from the planar, facetless part of an upper interface between the germanium region and the silicon, ranges between 20 and 150 nm.

6. Diode according to at least one of the preceding claims, wherein a metal silicide layer (12) is formed on the doped silicon regions (9, 10).

7. Diode according to claim 6, wherein spacers (11) laterally adjoin the insulating strip (8) and define a spacing between the insulating strip and the metal silicide layer (12).

8. Opto-electronic component, comprising a diode according to at least one of the preceding claims and a light guiding component (1) monolithically integrated with said diode.

9. Opto-electronic component according to claim 8, wherein the light guiding component is a waveguide (1) which is made of silicon and forms the lower interface with the germanium region (5) of the diode.

## Revendications

1. Une diode PIN latérale, présentant
- une région en germanium photosensible (5) qui est complètement noyée dans du silicium (1, 7) et qui forme avec le silicium (1, 7, 9, 10) une surface de frontière inférieure (1) et des surface de frontière latérales (6), dans laquelle les surface de frontière latérales ne sont pas perpendiculaires à la surface de frontière inférieure, mais sont obliques par rapport à cette surface de frontière inférieure, formant ainsi une forme de facette,
- dans laquelle la région de germanium (5) comporte une partie qui n'est qu'intrinsèquement conductrice (5a) s'étendant en dessous d'une bande de couche d'isolant (8) disposée sur le silicium (7), dont l'étendue latérale détermine la région intrinsèque de la diode, et
- dans laquelle des régions de germanium et de silicium dopées (5, 9, 10) jouxtent latéralement la partie intrinsèquement conductrice (5a) de la région de germanium (5), qui s'étendent latéralement de la région de germanium intrinsèque (5a) de la diode jusqu'à un bord de diode délimité par un isolant (3).

2. Diode selon la revendication 1, dans laquelle, à partir de la surface de frontière inférieure (1), la région de germanium (5) s'effile à mesure que la distance de la surface de frontière inférieure augmente, dans laquelle les surfaces de frontière latérales (6) sont réalisées préférentiellement par croissance épitaxiale sélective à une couche isolante de la région de germanium sur un substrat (1) en silicium orientée <100>.

3. Diode selon la revendication 1 ou 2, dans laquelle la hauteur totale de la diode au-dessus de la surface de frontière inférieure (1) est au plus de 700 nm, cette hauteur comprenant une épaisseur maximale de la région de germanium (5) au-dessus de la surface de frontière inférieure (1) et une épaisseur de couche de silicium (7) au-dessus de la région germanium.

4. Diode selon la revendication 3, dans laquelle la hauteur totale est d'au plus 500 nm.

5. Diode selon la revendication 3 ou 4, dans laquelle l'épaisseur de la partie de couche de silicium (7) par-dessus la région de germanium, calculée à partir de la partie planaire sans facette, d'une interface supérieure entre la région de germanium et le silicium est comprise entre 20 et 150 nm.

6. Diode selon au moins une des revendications précédentes comprenant une couche de siliciure métallique (12), qui est formée sur les régions de silicium dopées (9, 10).

7. Diode selon la revendication 6, dans laquelle des entretoises latérales (11) jouxtent les bandes de couche isolante (8), définissant une distance entre la bande de couche isolante et la couche de siliciure métallique (12).

8. Composant optoélectronique comprenant une diode selon au moins une des revendications précédentes et un élément conducteur de la lumière (1) intégré de façon monolithique à la diode.

9. Le composant optoélectronique selon la revendication 8, dans lequel l'élément conducteur de la lumière est un guide d'onde (1) réalisé en silicium et formant la surface de frontière inférieure avec la région de germanium (5) de la diode.
